# EUROPÄISCHE PATENTANMELDUNG

(11) **EP 0 749 059 A2**
(43) Veröffentlichungstag der Anmeldung: **18.12.1996**
(21) Anmeldenummer: 96201567.3
(22) Anmeldetag: 06.06.1996
(51) Int. Cl.: G05F 1/56

(54) **Telekommunikationsendgerät mit Spannungsregelschaltung**

(30) Priorität: 14.06.1995 DE 19521663
(71) Anmelder: Philips Patentverwaltung GmbH, 22335 Hamburg (DE); PHILIPS ELECTRONICS N.V., 5621 BA Eindhoven (NL)
(72) Erfinder: Heimerl, Emil, Dipl.-Ing., 91126 Schwabach (DE); Einzinger, Josef, Dipl.-Ing., 91166 Georgensmünd (DE); Hauenschild, Jürgen, Dipl.-Ing., 90491 Nürnberg (DE)
(74) Vertreter: Volmer, Georg, Dipl.-Ing.

(57) **Zusammenfassung**

Die Erfindung betrifft ein Telekommunikationsendgerät mit einer Spannungsregelschaltung (8), die wenigstens teilweise Bestandteil eines integrierten Schaltkreises (1) ist und die
- einen Differenzverstärker (14) mit einem ersten Eingang (+) zum Empfang einer Referenzspannung (UREF),
- Mittel (16, 20) zur Lieferung eines Laststromes an eine Last (22), die mit mindestens einem phasendrehenden Bauelement (23) beschaltet ist, in Abhängigkeit von einer Ausgangsspannung des Differenzverstärkers (14) und
- einen Rückkopplungszweig zur Rückkopplung einer an der Last (22) abfallenden Spannung auf den zweiten (-) der beiden Eingänge des Differenzverstärkers (14)
enthält.

Um Störungen der Ausgangsspannung über einen weiten Frequenzbereich weitestgehend zu unterdrücken und dabei die Stabilität der Spannungsregelschaltung zu gewährleisten, wird vorgeschlagen, das phasendrehende Bauelement (23) außerhalb des integrierten Schaltkreises (1) anzuordnen ist und zur Kopplung des phasendrehenden Bauelements (23) mit dem Ausgang der Mittel (16, 20) zur Lieferung eines Laststroms und dem Rückkopplungszweig mehrere getrennte Außenanschlüsse (4, 5) des integrierten Schaltkreises (1) vorzusehen. Die Erfindung betrifft auch einen entsprechenden integrierten Schaltkreis.

## Beschreibung

Die Erfindung betrifft ein Telekommunikationsendgerät mit einer Spannungsregelschaltung, die wenigstens teilweise Bestandteil eines integrierten Schaltkreises ist und die
- einen Differenzverstärker mit einem ersten Eingang zum Empfang einer Referenzspannung,
- Mittel zur Lieferung eines Laststromes an eine Last, die mit mindestens einem phasendrehenden Bauelement beschaltet ist, in Abhängigkeit von einer Ausgangsspannung des Differenzverstärkers und
- einen Rückkopplungszweig zur Rückkopplung einer an der Last abfallenden Spannung auf den zweiten der beiden Eingänge des Differenzverstärkers
enthält.

Ein solches Telekommunikationsendgerät ist insbesondere ein Mobilfunkendgerät. Die Erfindung läßt sich aber auch für andere Telekommunikationsendgeräte verwenden, z.B. für schnurgebundene und auch schnurlose Telefone.

Aus der EP 0 531 945 A2 ist eine Spannungsregelschaltung für kleine Spannungen bekannt, die einen als Operationsverstärker ausgeführten Differenzverstärker enthält, dessem nicht invertierenden Eingang eine Referenzspannung zugeführt wird. Der Ausgang des Operationsverstärkers steuert einen Leistungstransistor, der mit dem Ausgang der Spannungsregelschaltung gekoppelt ist und einen Strom über den Ausgang an eine angeschlossene Last liefert. Der Leistungstransistor ist mit einer an den Eingang der Spannungsregelschaltung angeschlossenen Spannungsquelle verbunden. Zwischen dem Leistungstransistor und dem Ausgang der Spannungsregelschaltung ist ein Kondensator parallel geschaltet.

Die Ausgangsspannung des Operationsverstärkers wird in dieser Schaltung mit Hilfe eines Rückkopplungszweiges, der eine Reihenschaltung aus einem Kondensator und einem Widerstand enthält, auf den invertierenden Eingang des Operationsverstärkers rückgekoppelt. Außerdem wird dem invertierenden Eingang des Operationsverstärkers die am Ausgang der Spannungsregelschaltung anliegende Spannung dem über einen Widerstand zugeführt.

Die interne Frequenzkompensation durch den einen Kondensator und einen Widerstand enthaltenden Rückkopplungszweig des Operationsverstärkers bewirkt eine Verringerung der Regelverstärkung schon in geringen Frequenzbereichen. Dies führt bei hochfrequenten Änderungen der Ausgangslast oder der Versorgungsspannung zu einer verlängerten Einschwingzeit der Spannungsregelschaltung. Dieses Problem tritt insbesondere bei Verwendung einer solchen Spannungsregelschaltung in einem integrierten Schaltkreis auf.

Der Erfindung liegt die Aufgabe zugrunde, ein Telekommunikationsendgerät mit einer Spannungsregelschaltung zu schaffen, bei dem Störungen der an die Spannungsregelschaltung gelieferten Versorgungsspannung über einen weiten Frequenzbereich nur einen vernachlässigbar kleinen Einfluß auf die an die Last gelieferte geregelte Ausgangsspannung der Spannungsregelschaltung haben. Außerdem soll die Stabilität der Spannungsregelschaltung bei solchen Störungen gewährleistet sein.

Die Aufgabe wird dadurch gelöst, daß das phasendrehende Bauelement außerhalb des integrierten Schaltkreises angeordnet ist und daß zur Kopplung des phasendrehenden Bauelements mit dem Ausgang der Mittel zur Lieferung eines Laststroms und dem Rückkopplungszweig mehrere getrennte Außenanschlüsse des integrierten Schaltkreises vorgesehen sind.

Das phasendrehende Bauelement dient zur Stabilisierung der Spannungsregelschaltung. Insbesondere ist das phasendrehende Bauelement eine Kondensatoranordnung, jedoch ist auch eine Realisierung mittels einer Anordnung aus ein oder mehreren induktiven Bauelementen möglich. Das phasendrehende Bauelement liefert den zur Stabilisierung der Regelschaltung notwendigen Pol. Dieser kann bei einer Realisierung mittels Kondensatoranordnung auch bei kleinen Kapazitätswerten der Kondensatoranordnung aufgrund der Breitbandigkeit des Differenzverstärkers erzeugt werden kann. Da das phasendrehende Bauelement zusammen mit der Last von außen an den integrierten Schaltkreis angeschlossen wird, ist man bei der Realisierung der im Vergleich zur Realisierung auf dem Chip des integrierten Schaltkreises variabler.

Allerdings stellt sich bei dem von außen angeschlossenen phasendrehenden Bauelement das Problem, daß dieses für hohe Frequenzen bei Verwendung nur eines Außenanschlusses ("Pin") durch parasitäre Induktivitäten von dem Regelkreis der Spannungsregelschaltung entkoppelt wird und so seine Wirksamkeit verliert. Die parasitären Induktivitäten haben ihre Ursache insbesondere in Leitungsinduktivitäten der Anschlußdrähte, mit denen die Außenanschlüsse des integrierten Schaltkreises mit dessem Chip durch Bonden verbunden sind, in Leitungsinduktivitäten der Leitungen von den Außenanschlüssen zum phasendrehenden Bauelement bzw. zur Last und in der Induktivität des Gehäuses des integrierten Schaltkreises. Indem zwei getrennte Außenanschlüsse verwendet werden, die beide mit dem aus phasendrehenden Bauelement und Last bestehenden Schaltungsteil verbunden sind, wird eine Entkopplung des phasendrehenden Bauelements vom Regelkreis für hohe Frequenzen vermieden, die durch parasitäre Induktivitäten bedingt ist. Einer der beiden Außenanschlüsse dient als Sensoreingang, über den auch für hohe Frequenzen die an dem aus phasendrehenden Bauelement und Last bestehenden Schaltungsteil anliegende Spannung auf den Regelkreis einwirkt, so daß das phasendrehende Bauelement seine Wirkung auch für hohe Frequenzen nicht verliert.

In einer Ausgestaltung der Erfindung enthalten die Mittel zur Lieferung eines Laststroms eine Transistoranordnung und es ist eine Kaskodeschaltung zur Kopplung des Ausgangs des Differenzverstärkers mit dem Steuereingang der den Laststrom liefernden Transistoranordnung vorgesehen. Die Kaskodeschaltung dient zur Impedanzwandlung. Sie läßt die am Ausgang der Regelschaltung und damit am Ausgang der Transistoranordnung anliegende Last niederohmig erscheinen.

Ein andere Ausgestaltung der Erfindung hat innerhalb des integrierten Schaltkreises für den Differenzverstärker und die Kaskodeschaltung zwei getrennte Masseleitungen, die über zwei Außenanschlüsse des integrierten Schaltkreises mit einer äußeren Masseleitung gekoppelt sind. Bei Schwankungen bzw. Störungen der von einer externen Spannungsquelle (z.B. einer Batterie) gelieferten Versorgungsspannung tritt bei Verwendung nur einer Masseleitung innerhalb des integrierten Schaltkreises und damit auch nur eines Außenanschlusses zum Anschluß eines externen Massepotentials das Problem auf, daß die diesem Außenanschluß zugeordneten parasitären Induktivitäten zu Schwankungen des internen (innerhalb des integrierten Schaltkreises auftretenden) Massepotentials führen. Über die Kaskodeschaltung fließt dann im Vergleich zum Differenzverstärker ein hoher Strom, der entsprechend seiner Größe zu einer Verschiebung des internen Massepotentials führt, was wiederum in unerwünschter Weise eine Rückwirkung auf den Differenzverstärker hat. Bei Entkopplung der Masseleitungen für die Kaskodeschaltung und den Differenzverstärker innerhalb des integrierten Schaltkreises auf die beschriebene Weise wird das Massepotential für den Differenzverstärker nicht durch den Stromfluß durch die Kaskodeschaltung beeinflußt und bleibt somit annähernd konstant. Eine Beeinträchtigung der Funktion des Differenzverstärkers wird durch Massepotentialschwankungen wird vermieden.

Indem ein Spannungsteiler zur Kopplung der Last mit dem Rückkopplungszweig vorgesehen ist, läßt sich auf einfache Weise die am Ausgang der Spannungsregelschaltung gelieferte geregelte Spannung einstellen. Das zugehörige Spannungsteilerverhältnis läßt sich insbesondere durch einen an sich bekannten programmierbaren Spannungsteiler leicht einstellen und variieren.

Ein weitere Ausgestaltung ist dadurch gekennzeichnet, daß eine Konstantspannungsquelle, die über einen Außenanschluß des integrierten Schaltkreises mit einer äußeren Spannungsquelle gekoppelt ist, zur Lieferung der Referenzspannung vorgesehen ist. Auf diese Weise kann eine unter Umständen stark schwankende Versorgungsspannung der äußeren Spannungsquelle auf einfache Weise auf eine als Referenzspannung dienende Referenzspannung reduziert werden. Die so erzeugte Referenzspannung unterliegt wesentlich kleineren Schwankungen als die Versorgungspannung, so daß auch die von der Spannungsregelschaltung an deren Ausgang gelieferte geregelte Spannung konstant gehalten werden kann. Zur Erzeugung der Referenzspannung können auch mehrere Konstantspannungsquellen zu einer Konstantspannungsquelle zusammengefaßt werden.

Zwischen der Konstantspannungsquelle und dem Breitband-Differenzverstärker einen Tiefpaß anzuordnen, ist eine weitere vorteilhafte Weiterbildung der Erfindung. Konstantspannungsquellen haben im Regelfall Tiefpaßcharakter, so daß im vorliegenden Anwendungsfall der Versorgungsspannung (der äußeren Spannungsquelle) überlagerte hochfrequente Störungen gedämpft werden. Für den Fall, daß die Tiefpaßgrenzfrequenz der Konstantspannungsquelle nicht ausreichend groß ist und ein Teil der Störungen nicht ausreichend gedämpft wird, sorgt der zusätzliche Tiefpaß für eine Dämpfung auch dieser Anteile der Störungen.

Die Erfindung betrifft auch einen integrierten Schaltkreis mit einer Spannungsregelschaltung mit
- einem Differenzverstärker mit einem ersten Eingang zum Empfang einer Referenzspannung,
- Mitteln zur Lieferung eines Laststromes an eine Last in Abhängigkeit von einer Ausgangsspannung des Differenzverstärkers, wobei die Last innerhalb oder außerhalb des integrierten Schaltkreises angeordnet ist und die Last mit mindestens einem phasendrehenden Bauelement beschaltet ist, und
- einem Rückkopplungszweig zur Rückkopplung einer an der Last abfallenden Spannung auf den zweiten der beiden Eingänge des Differenzverstärkers,
wobei zur Kopplung des außerhalb des integrierten Schaltkreises anzuordnenden phasendrehenden Bauelements mit dem Ausgang der Mittel zur Lieferung eines Laststroms und dem Rückkopplungszweig mehrere getrennte Außenanschlüsse des integrierten Schaltkreises vorgesehen sind.

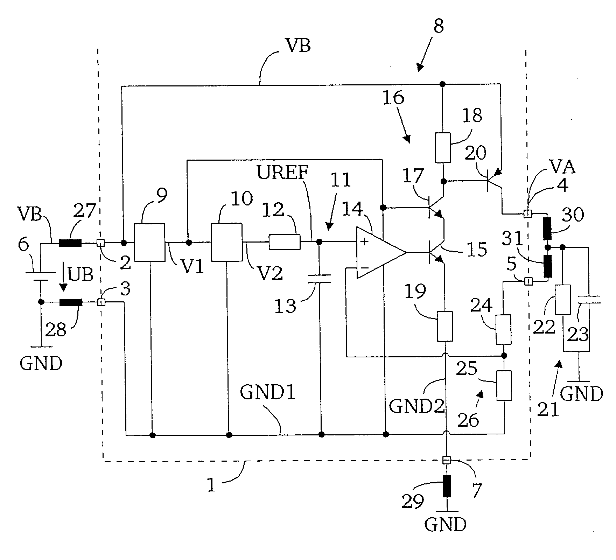

Ein Ausführungsbeispiel der Erfindung wird nachstehend anhand der Zeichnung näher erläutert.

Die Figur zeigt einen integrierten Schaltkreis mit einer Spannungsregelschaltung.

Der durch eine gestrichelte Linie angedeutete integrierte Schaltkreis 1 ist nur insoweit in der Figur dargestellt, wie es für die Darstellung der Erfindung notwendig ist. Aus Gründen der Übersichtlichkeit wurden die übrigen Teile des integrierten Schaltkreises weggelassen. Der integrierte Schaltkreis 1 weist Außenanschlüsse 2, 3, 4 und 5 auf. Die Außenanschlüsse 2 und 3 sind mit einer externen Spannungsquelle 6 verbunden, so daß am Außenanschluß 2 ein Potential VB und am Außenanschluß 3 ein Massepotential GND anliegt. Das Massepotential GND wird von außen über einen weiteren Außenanschluß 7 dem integrierten Schaltkreis 1 zugeführt. Die Spannungsquelle 6 ist insbesondere eine Batterie, die eine Versorgungsspannung UB liefert, die beispielsweise zwischen 3 und 7 Volt schwankt.

Über die Außenanschlüsse 2, 3 und 7 wird die Versorgungsspannung UB einer Spannungsregelschaltung 8 zugeführt. Diese ist auf dem nicht näher dargestellten Halbleiterchip des integrierten Schaltkreises 1 realisiert. Am Eingang der Spannungsregelschaltung 8 ist eine erste Konstantspannungsquelle 9 angeordnet, der über die Außenanschlüsse 2 und 3 die Versorgungsspannung UB bzw. das Potential VB und das Massepotential GND zugeführt werden. Die über den Außenanschluß 3 mit dem externen Massepotential GND gekoppelte Masseleitung innerhalb des integrierten Schaltkreises ist mit GND1 bezeichnet. Die erste Konstantspannungsquelle 9 erzeugt aus der Versorgungsspannung UB ein Potential V1, das beispielsweise den Wert 2,6 Volt hat. Dieses Potential V1 wird einer zweiten Konstantspannungsquelle 10, die ebenfalls mit der Masseleitung GND1 verbunden ist, zugeführt. Die zweite Konstantspannungsquelle 10 bildet daraus ein Potential V2, das beispielsweise den Wert 1,2 Volt hat. Das Potential V2 wird einem Tiefpaß 11 zugeführt, der aus einem Widerstandselement 12 und einem kapazitiven Element 13 besteht, und dessen Ausgang mit dem nicht invertierenden Eingang eines Breitband-Differenzverstärkers 14 verbunden ist, um diesem Eingang eine Referenzspannung UREF zuzuführen. Zur Spannungsversorgung wird dem Differenzverstärker 14 das Potential V1 und das Massepotential GND1 zugeführt.

Der Ausgang des Differenzverstärkers 14 ist mit dem Basisanschluß des Eingangstransistors 15 einer Kaskodeschaltung 16 gekoppelt. Die Kaskodeschaltung 16 enthält weiterhin einen Ausgangstransistor 17, dessen Basisanschluß das Potential V1 zugeführt wird. Der Kollektor des Transistors 17 ist über einen Kollektorwiderstand 18 mit dem Potential VB gekoppelt. Der Emitter des Eingangstransistors 15 ist über einen Emitterwiderstand 19 mit dem Massepotential GND2 gekoppelt. Die Kaskodeschaltung 16 dient zur Impedanzwandlung, so daß für die Spannungsregelschaltung die angeschlossene Last 22 niederohmig erscheint. Um die Leistung der Kaskodeschaltung zu erhöhen, können den Widerständen 18 und 19 und den Transistoren 15 und 17 weitere Widerstände bzw. Transistoren parallel geschaltet werden.

Der Kollektor des Ausgangstransistors 17 der Kaskodeschaltung 16 ist mit dem Basisanschluß einen PNP-Leistungstransistors 20 verbunden, dessen Emitter das Potential VB zugeführt wird.

Der Kollektor des Leistungstransistors 20 ist über den Außenanschluß 4 mit einer Parallelschaltung 21 aus einer Last 22 und einer im vorliegenden Fall aus nur einem Kondensator 23 bestehenden Kondensatoranordnung gekoppelt. Die Parallelschaltung 21 stellt eine externe Beschaltung des integrierten Schaltkreises 1 bzw. der Spannungsregelschaltung 8 dar. Der mit dem Außenanschluß 4 verbundene Anschluß der Parallelschaltung 21 ist ebenfalls mit dem Außenanschluß 5 verbunden, der über einen aus zwei Widerständen 24 und 25 bestehenden Spannungsteiler 26 mit dem Massepotential GND1 gekoppelt ist. Die am Mittelabgriff des Spannungsteilers 26 anliegende Spannung wird dem invertierenden Eingang des Breitband-Differenzverstärkers 14 zugeführt. Über den Außenanschluß 5 und den Spannungsteiler 26 kann somit eine an der Parallelschaltung 21 und damit eine an der Last 22 abfallende Spannung auf den invertierenden Eingang des Differenzverstärkers 14 rückgekoppelt werden. Der Spannungsteiler 26 ermöglicht eine einfache Einstellung des Spannungswertes des geregelten Ausgangspotentials VA bzw. der geregelten Ausgangsspannung durch Einstellung eines entsprechenden Spannungsteilerverhältnisses. Typische Werte für die geregelte Ausgangsspannung liegen bei ca. 3 Volt.

Der Differenzverstärker 14 hat eine Bandbreite, die wesentlich größer ist als die Bandbreite der gesamten Spannungsregelschaltung. Dies ist notwendig, da der Differenzverstärker 14 Störungen bzw. Schwankungen der Versorgungsspannung UB bzw. des Potentials VB über einen weiten Frequenzbereich unterdrücken soll. Solche Störungen werden auch schon durch die Konstantspannungsquellen 9 und 10 unterdrückt, die Tiefpaßcharakter besitzen. Um die Tiefpaßfilterung durch die Konstantspannungsquellen 9 und 10 zu unterstützen, kann optional, wie in der Figur beschrieben, ein Tiefpaß 11 zwischen die Konstantspannungsquelle 10 und den nicht invertierenden Eingang des Differenzverstärkers 14 zur Lieferung der Referenzspannung UREF zwischengeschaltet werden.

Am Außenanschluß 4 liegt das geregelte Ausgangspotential VA der Spannungsregelschaltung 8 an. Die Potentialdifferenz zwischen dem Ausgangspotential VA und dem externen Massepotential GND ist die geregelte Ausgangsspannung der Spannungsregelschaltung 8. Sie kann sowohl wie in diesem Ausführungsbeispiel zur Versorung einer externen Last 22 als auch zur Versorgung einer internen, d.h. innerhalb des integrierten Schaltkreises 1 angeordneten Last verwendet werden. Der entsprechende geregelte Laststrom wird vom Leistungstransistor 20 geliefert.

Der extern angeschlossene Kondensator 23 dient zur Stabilisierung der Spannungsregelschaltung 8. Er liefert den zur Stabilisierung der Schaltung notwendigen dominanten Pol. Je breitbandiger der Differenzverstärker 14 ist, desto kleinere Kapazitätswerte kann der Kondensator 23 haben, ohne daß die Spannungsregelschaltung instabil wird. Ein typischer Wert für die Kapazität des Kondensators 23 ist 100 nF. Gegenüber handelsüblichen Spannungsregelschaltungen ist die erforderliche Kapazität des Kondensators 23 abgesenkt. Es ergibt sich eine vereinfachte Dimensionierung der externen Beschaltung des integrierten Schaltkreises 1.

In der Figur sind weiterhin parasitäre Induktivitäten 27, 28, 29, 30 und 31 dargestellt. Diese werden für hohe Frequenzen an den Außenanschlüssen 2, 3, 4, 5 und 7 des integrierten Schaltkreises 1 wirksam. Bei hochfrequenten Störungen der Versorgungsspannung UB bzw. des Potentials VB schwankt das mit der Kaskodeschaltung 16 gekoppelte interne Massepotential GND2 aufgrund der Wirksamkeit der parasitären Induktivität 29, über die das interne Massepotential GND2 mit dem externen Massepotential GND gekoppelt ist. Um eine Rückwirkung solcher Schwankungen auf das Massepotential GND1, das dem Differenzverstärker 14 zugeführt wird, zu verhindern, sind die internen Massepotentiale GND1 und GND2 innerhalb des integrierten Schaltkreises 8 getrennt. Sie werden über die zwei Außenanschlüsse 3 und 7 separat mit dem externen Massepotential GND gekoppelt. Auf diese Weise kann das dem Differenzverstärker 14 zugeführte Massepotential GND1 auch bei Störungen der Versorgungsspannung UB bzw. des Potentials VB im wesentlichen konstant gehalten werden.

Für hochfrequente Störungen der Versorgungsspannung UB, die sich in hochfrequenten Anteilen des geregelten Ausgangspotentials VA am Außenanschluß 4 bemerkbar machen, wird sowohl die mit dem Außenanschluß 4 verbundene parasitäre Induktivität 30 als auch die mit dem Außenanschluß 5 verbundene parasitäre Induktivität 31 wirksam. Beide Induktivitäten 30 und 31 haben dann hohe Impedanzwerte. Dies führt dazu, daß entsprechende hochfrequente vom Leistungstransistor 20 gelieferte Lastströme im wesentlichen über die Parallelschaltung 21 zum Massepotential GND abfließen. Über die parasitäre Induktivität und den Außenanschluß 5 fließt nur ein sehr geringer Teil der hochfrequenten Anteile des Laststromes. Die Spannung am Außenanschluß 5 ist somit im wesentlichen gleich der an der Parallelschaltung 21 abfallenden Spannung aufgrund der hohen Impedanz der parasitären Induktivität 31 für hohe Frequenzen, so daß der Außenanschluß 5 hier als Fühler für die an der Parallelschaltung 21 abfallende Spannung dient. Die für die Stabilität der Spannungsregelschaltung 8 erforderliche Wirksamkeit des Kondensators 23 bleibt sichergestellt. Dieser wird nicht vom Rückkopplungszweig der Spannungsregelschaltung 8 und somit vom invertierenden Eingang des Differenzverstärkers 14 entkoppelt. Bei Verwendung nur eines Außenanschlusses zum Anschluß der Parallelschaltung 21 aus der Last 22 und dem Kondensator 23 tritt aufgrund der parasitären Induktivität des Außenanschlusses eine Entkopplung des angeschlossenen Kondensators vom Rückkopplungszweig ein, so daß die so ausgeführte Spannungsregelschaltung instabil wird.

Der beschriebene integrierte Schaltkreis weist eine Spannungsregelschaltung auf, die eine sehr gute Entkopplung der geregelten Ausgangsspannung von der Versorgungsspannung UB aufweist. Störungen der Versorgungsspannung UB können für einen weiten Spannungsschwankungsbereich und einen weiten Frequenzbereich kompensiert werden. Anstatt die Last 22 mit dem Kondensator 23 zu beschalten, kann prinzipiell auch eine Beschaltung der Last 22 mit einer Anordnung aus mehreren Kondensatoren oder mit einer Anordnung aus ein oder mehreren Induktivitäten oder einer aus ein oder mehreren Kondensatoren und ein oder mehreren Induktivitäten bestehenden Anordnung zu demselben Zweck erfolgen. Die dargestellt Anordnung ist Teil eines Telekommunikationsendgeräts, z. B. eines Mobilfunkendgeräts, und dient zu dessen Spannungsversorgung. Die weiteren Teile des Telekommunikationsendgerät sind nicht dargestellt, da dies zum Verständnis der Erfindung nicht erforderlich ist.

## Patentansprüche

1. Telekommunikationsendgerät mit einer Spannungsregelschaltung (8), die wenigstens teilweise Bestandteil eines integrierten Schaltkreises (1) ist und die
- einen Differenzverstärker (14) mit einem ersten Eingang (+) zum Empfang einer Referenzspannung (UREF),
- Mittel (16, 20) zur Lieferung eines Laststromes an eine Last (22), die mit mindestens einem phasendrehenden Bauelement (23) beschaltet ist, in Abhängigkeit von einer Ausgangsspannung des Differenzverstärkers (14) und
- einen Rückkopplungszweig zur Rückkopplung einer an der Last (22) abfallenden Spannung auf den zweiten (-) der beiden Eingänge des Differenzverstärkers (14)
enthält,
dadurch gekennzeichnet,
daß das phasendrehende Bauelement (23) außerhalb des integrierten Schaltkreises (1) angeordnet ist und
daß zur Kopplung des phasendrehenden Bauelements (23) mit dem Ausgang der Mittel (16, 20) zur Lieferung eines Laststroms und dem Rückkopplungszweig mehrere getrennte Außenanschlüsse (4, 5) des integrierten Schaltkreises (1) vorgesehen sind.

2. Telekommunikationsendgerät nach Anspruch 1,
dadurch gekennzeichnet,
daß die Mittel (16, 20) zur Lieferung eines Laststroms eine Transistoranordnung (20) enthalten und
daß eine Kaskodeschaltung (16) zur Kopplung des Ausgangs des Differenz verstärkers (14) mit dem Steuereingang der den Laststrom liefernden Transistoranordnung (20) vorgesehen ist.

3. Telekommunikationsendgerät nach Anspruch 2,
dadurch gekennzeichnet,
daß innerhalb des integrierten Schaltkreises (1) für den Differenzverstärker (14) und die Kaskodeschaltung (16) zwei getrennte Masseleitungen (GND1, GND2), die über zwei Außenanschlüsse (3, 7) des integrierten Schaltkreises (1) mit einer äußeren Masseleitung (GND) gekoppelt sind, vorgesehen sind.

4. Telekommunikationsendgerät nach einem der Ansprüche 1 bis 3,
dadurch gekennzeichnet,
daß ein Spannungsteiler (24, 25) zur Kopplung der Last (22) mit dem Rückkopplungszweig vorgesehen ist.

5. Telekommunikationsendgerät nach einem der Ansprüche 1 bis 4,
dadurch gekennzeichnet,
daß eine Konstantspannungsquelle (9, 10), die über einen Außenanschluß (2) des integrierten Schaltkreises (1) mit einer äußeren Spannungsquelle (6) gekoppelt ist, zur Lieferung der Referenzspannung (UREF) vorgesehen ist.

6. Telekommunikationsendgerät nach Anspruch 5,
dadurch gekennzeichnet,
daß zwischen der Konstantspannungsquelle (9, 10) und dem Differenzverstärker (14) ein Tiefpaß (11) angeordnet ist.

7. Telekommunikationsendgerät nach einem der Ansprüche 1 bis 6,
dadurch gekennzeichnet,
daß die Spannungsregelschaltung (8) im integrierten Schaltkreis (1) angeordnet ist und daß sowohl die Last (22) als auch das phasendrehende Bauelement (23) außerhalb des integrierten Schaltkreises (1) angeordnet sind.

8. Telekommunikationsendgerät nach einem der Ansprüche 1 bis 7,
dadurch gekennzeichnet,
daß als phasendrehendes Bauelement ein Kondensator (23) vorgesehen ist, der parallel zur Last (22) geschaltet ist.

9. Integrierter Schaltkreis (1) mit einer Spannungsregelschaltung (8) mit
- einem Differenzverstärker (14) mit einem ersten Eingang (+) zum Empfang einer Referenzspannung (UREF),
- Mitteln (16, 20) zur Lieferung eines Laststromes an eine Last (22) in Abhängigkeit von einer Ausgangsspannung des Differenzverstärkers (14), wobei die Last (22) innerhalb oder außerhalb des integrierten Schaltkreises (1) angeordnet ist und die Last (22) mit mindestens einem phasendrehenden Bauelement (23) beschaltet ist, und
- einem Rückkopplungszweig zur Rückkopplung einer an der Last (22) abfallenden Spannung auf den zweiten (-) der beiden Eingänge des Differenzverstärkers (14),
dadurch gekennzeichnet,
daß zur Kopplung des außerhalb des integrierten Schaltkreises anzuordnenden phasendrehenden Bauelements (23) mit dem Ausgang der Mittel zur Lieferung eines Laststroms (16, 20) und dem Rückkopplungszweig (31, 5, 24) mehrere getrennte Außenanschlüsse (4, 5) des integrierten Schaltkreises (1) vorgesehen sind.
